# EUROPEAN PATENT APPLICATION

(11) **EP 0 651 435 A1**
(43) Date of publication of application: **03.05.1995**
(21) Application number: 94115056.7
(22) Date of filing: 23.09.1994
(51) Int. Cl.: H01L 21/314, H01L 29/06

(54) **Semiconductor device comprising a SIPOS field plate and its manufacturing method**

(30) Priority: 29.09.1993 JP 242268/93
(71) Applicant: FUJI ELECTRIC CO. LTD., Kawasaki 210 (JP)
(72) Inventor: Matsuzaki, Kazuo, Kawasaki-ku, Kawasaki 210 (JP)
(74) Representative: May, Hans Ulrich, Dr.

(57) **Abstract**

Object:
To eliminate inconveniences arising from the porosity of a SIPOS film or the loose bonding of oxygen and Si atoms when a field plate comprising a SIPOS film (11) is sandwiched by oxide films (13; 14) to reduce stress of the field plate.

Constitution:
When the surface layer is thermally oxidized to form an oxide film (14) as a top layer after a SIPOS film (11) is formed, the SIPOS film will be dense and its film quality will be uniform. To prevent this thermal oxidization process from affecting the depth of an impurity diffusion layer and a gate oxide film, a SIPOS film and both oxide films are formed immediately after a field oxide film is formed. After this process, an impurity diffusion layer and a gate oxide film are formed.

## Description

The present invention relates to a semiconductor device including a field plate on a semiconductor substrate to maintain reliability of high voltage devices and a manufacturing method.

Thin films of semi-insulating polycrystalline silicon (SIPOS) have conventionally been used as resistive field plate films to maintain reliability of high voltage devices, in particular, those of a MOS type structure.

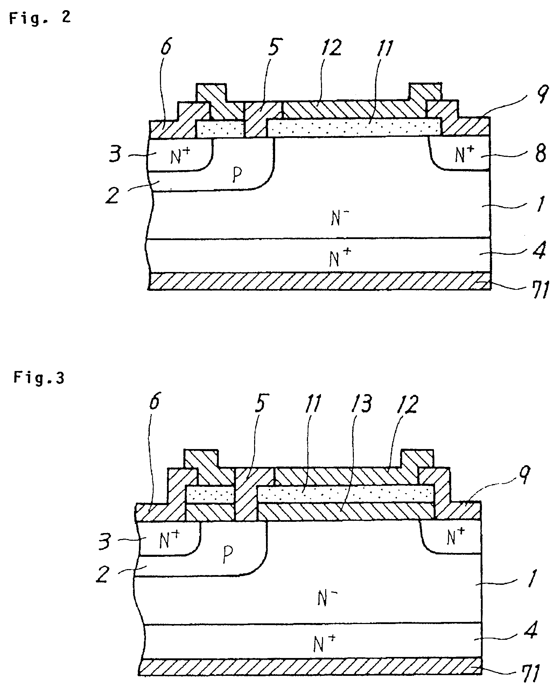

The SIPOS thin film is generally an oxygen-containing polycrystalline silicon film formed at a substrate temperature of 650° C by a CVD method using SiH₄ and N₂O, and the concentration of oxygen atoms in SIPOS is about 25%. Figures 2 and 3 show examples of a semiconductor device having such a field plate. These semiconductor devices are bipolar transistors wherein a P base region 2 is formed on the surface layer of a N⁻ silicon substrate 1, an N⁺ emitter region 3 is selectively formed thereon, and a N⁺ collector layer 4 is formed on the rear surface of the substrate and which have Al electrodes 5 and 6 that contact the P region 2 and N+ region 3 respectively to act as base and emitter electrodes as well as a three-layer film electrode 71, Ti-Ni-Ag, that contacts the under lying N⁺ layer to act as a collector electrode. A SIPOS thin film 11 on the field plate contacts the emitter electrode 6, the base electrode 5, and an N+ peripheral region 8 located in the periphery of the substrate, and is provided between the base electrode 5 and a peripheral electrode 9 of a potential equal to that of the electrode 71. In Figure 2, the SIPOS thin film 11 0.5 µm in thickness that also serves to protect the surface is formed directly on the surface of the drift region of an N⁻ silicon substrate 1, and an SiO₂ film 12 1 µm in thickness is formed thereon by a CVD method. In Figure 3, the SIPOS thin film 11 is formed via a thermally oxidized film 13 1 µm in thickness that serves to protect the surface, and the CVD SiO₂ film 12 is coated thereon.

### [Problems to Be Solved by the Invention]

As MIMURA et al. have reported in IEEE Electron Device Let. Vol. ED-6, No. 4, p. 189 (1985), compared with the structure in Figure 3, the structure in Figure 2 has disadvantages in that a large leakage current is generated near junctions and that h_{Fe} is small. Thus, the structure in Figure 3 is presently used for every application. When it comes to practical use, however, the structure in Figure 3 also exhibits disadvantages in that a leakage current is not uniform, that the structure has temperature characteristics, and that cracks may occur due to stress. As, for example, Maxwell et al. have revealed in their study of the physical properties of the SIPOS thin film which was reported in J. Electrochemical Soc. Vol. 128, No. 3, p. 576 (1981), these disadvantages are due to the fact that the SIPOS thin film formed at a substrate temperature of about 650° C is inherently porous, that the distribution of oxygen atoms in the thin film is ununiform, that the bonding of oxygen and Si atoms is loose, and that its stress acts as tensile stress on the structure. These problems also exist when the SIPOS region is provided on the surface of the drift region of a MOS semiconductor device as a resistive field plate.

It is the object of this invention to provide a semiconductor device wherein the formed field plate does not have these disadvantages due to the inherent physical properties of the SIPOS thin film, and a manufacturing method.

### [Means for Solving the Problems]

In order to achieve the above object, this invention provides a semiconductor device having on the surface of a semiconductor substrate a resistive field plate comprising a SIPOS film sandwiched by silicon oxide films, wherein both silicon oxide films sandwiching the SIPOS film are thermally oxidized films. The silicon oxide film that contacts the SIPOS film on the opposite side of the substrate should be covered with an insulation film formed at a low temperature. It is effective that the insulation film formed at a low temperature is an silicon oxide or silicon nitride film generated by a CVD method. A manufacturing method of such a semiconductor device has processes of forming a field silicon oxide film on the semiconductor substrate by thermal oxidation, then generating a SIPOS film, and thermally oxidizing the surface layer of the polycrystalline silicon film. The manufacturing of a semiconductor device should also have a process of forming an insulation film at 400° C or lower to coat it on the surface after each process.

### [Effects of the Invention]

Stress in the SIPOS film can be canceled by sandwiching the SIPOS film between thermally oxidized films. When the top layer is thermally oxidized after a SIPOS film is formed, the SIPOS film naturally becomes dense, providing a homogeneous and stable film structure. However, when the SIPOS film is thermally oxidized, high-temerature heat treatment may adversely affect the depth of an impurity diffusion layer, a gate oxide film in a MOS structure, or an contacting surface between the gate oxide film and silicon. In a sequence of element manufacturing processes, the processes of thermal oxidization/formation of a SIPOS film/thermal oxidization must thus be carried out before the impurity diffusion and gate oxidization processes and immediately after the formation of a field oxide film. A final protective film or an interlayer insulation film must be formed on the field plate, and an insulation film formed at 400° C or lower such as a final protective film or an interlayer insulation film must be formed on the thermally oxidized film/SIPOS film/thermally oxidized film.

### [Embodiments]

A manufacturing process of a power MOSFET that is an embodiment of this invention is described with reference to Figures 1(a) to (g) wherein the corresponding components carry the same reference numerals as in Figures 2 and 3.

The surface of a silicon substrate comprising an N layer 1 and an N⁺ layer 4 was thermally oxidized to form a thermally oxidized film 13 1 µm in thickness. A SIPOS film 11 was then formed under the following conditions.

| | |
|---|---|
| gas flow ratio, N₂O/SiH₄: | 0.22 |
| carrier gas, N₂ flow: | 400 SCCM |
| degree of vacuum during formation of film: | 21.3 Pa (0.16 Torr) |
| temperature of substrate: | 637° C |
| oxygen concentration in film: | 25 atom % |
| film formation speed: | 3.5 nm/min. |
| film thickness: | 1 µm |

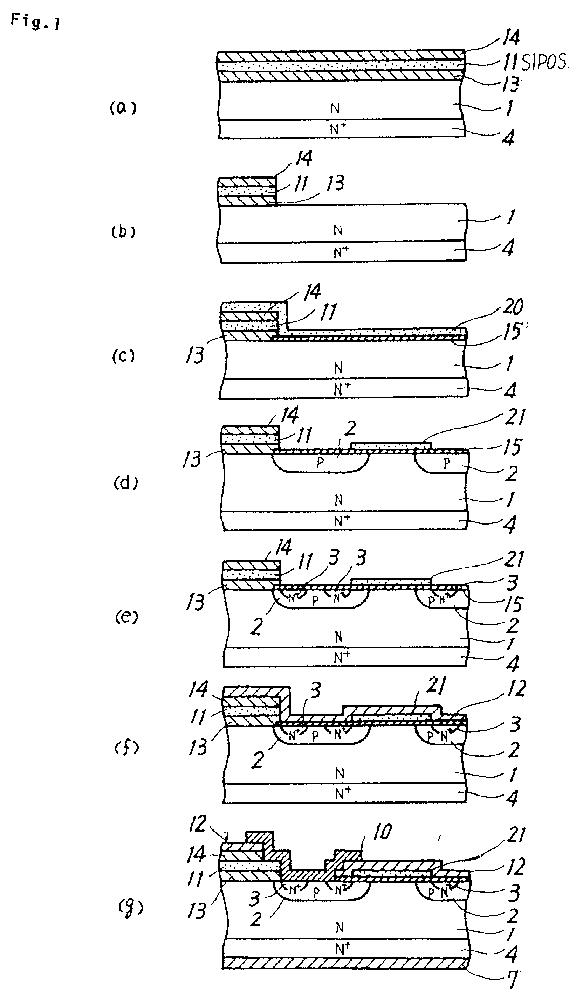

The surface of the SIPOS film was then oxidized for 0.5 µm to form a thermally oxidized film 14 [Figure 1(a)]. That part of the oxide film 14, SIPOS film 11, and oxide film 13 which is not a drift region was removed by ordinary photolithography [Figure 1(b)]. A gate oxide film 15 0.1 µm in thickness was formed and a polycrystalline silicon layer 20 was accumulated (Figure 1(c)). After a photolithography polycrystalline silicon layer 20 was patterned to form a gate oxide electrode 21, boron ions were implanted using the gate electrode 21 as a mask, and a P well 2 was formed by annealing (Figure 1(d)). A self matching method wherein the gate electrode is used as mask to implant phosphorus ions was used to form an N⁺ source region 3 (Figure 1(e)). A low temperature CVD method was used to form an SiO₂ film 12 1 µm in thickness as an interlayer insulation film (Figure 1(f)). Contact openings for the source and the gate section were created in the interlayer insulation film 12. At this point, the CVD SiO₂ film 12 and termally oxidized film 14 were removed in part of the periphery of the source section to expose part of the SIPOS film 11. An Al layer was deposited and formed as an electrode and wiring. Since the Al electrode 10 was connected not only to the N+ source region 3 and P well 2 but also to the SIPOS film, the SIPOS film 11 extending to the outer circumference of the substrate acts as a resistive field plate. Finally, a three layer electrode 7, Ti-Ni-Ag, was formed as a drain electrode to obtain a vertical type power MOSFET (Figure 1(g)). A silicon nitride film may be formed by a CVD method instead of the SiO₂ film formed by a low temperature CVD method.

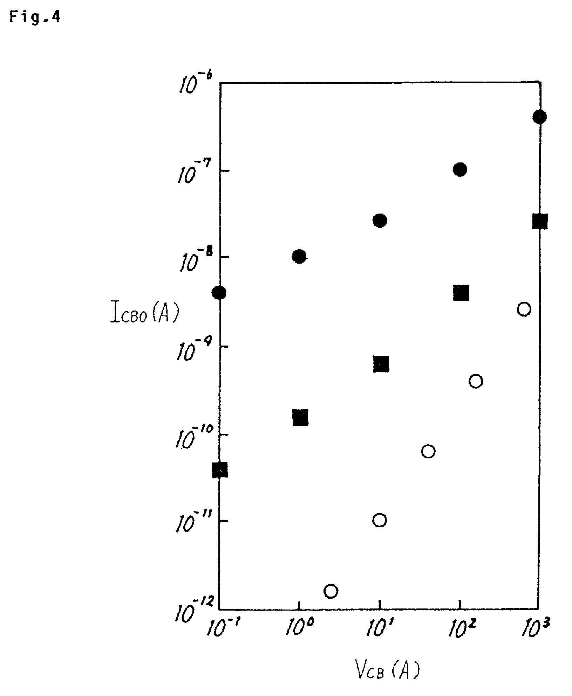

Figure 4 shows the results of the comparison of the reverse bias leakage current between the base and collector of the NPN transistors in Figures 2 and 3 that has a structure similar to those of the NPN transistors in Figures 2 and 3 and is manufactured using a process similar to that in Figure 1 to form the P well 2 as a base and the N⁺ region 3 as an emitter. The mark ● represents the transistor shown in Figure 2, the mark ■ represents the transistor shown in Figure 3, and the mark ○ represents the transistor in accordance with the embodiment of this invention; the thickness of the SIPOS film as a field plate is 0.5 µm in all the transistors. As is apparent from the figures, this invention serves to reduce the reverse bias leakage current between the base and collector. The variation of the reverse bias leakage current of these transistors at room temperature is ±10% for ●, ±8% for ■, and ±3% for ○; the transistor in accordance with the embodiment of this invention had the least variation.

### [Advantages of the Invention]

According to this invention, only when, in a semiconductor device using a resistive field plate comprising a SIPOS film sandwiched by oxide films that are reliable due to their stress-related advantage, the oxide films on SIPOS film are formed by thermal oxidization of SIPOS, the reverse leakage current can be reduced substantially, the variation of this current can also be reduced, and the SIPOS film can be applied as a key technology for maintaining reliability of high voltage devices.

### [Brief Description of the Drawings]

Figure 1 is a cross sectional view illustrating a manufacturing process of a vertical type MOSFET that is an embodiment of the present invention in the order of (a) to (g).

Figure 2 is a cross sectional view of an example of transistor having a conventional SIPOS film field plate.

Figure 3 is a cross sectional view of another example of transistor having a conventional SIPOS film field plate.

Figure 4 is a chart illustrating the relationship of the reverse bias leakage current between the base and collector of the embodiment of this invention and that of a conventional example of bipolar transistor.

### [Description of Symbols]

- 1: N layer
- 2: P well
- 3: N⁺ source region
- 4: N⁺ layer
- 7: Ti-Ni-Ag electrode
- 10: Al electrode
- 11: SIPOS film
- 12: LTOCVD SiO₂ film
- 13, 14: thermally oxidized film
- 15: gate oxide film
- 21: gate electrode

## Claims

1. A semiconductor device having on the surface of a semiconductor substrate a resistive field plate comprising an oxygen-containing polycrystalline silicon film (11) sandwiched by silicon oxide films (13;14), wherein both silicon oxide films sandwiching the oxygen-containing polycrystal silicon film are thermally oxidized films.

2. The semiconductor device of Claim 1 wherein the silicon oxide film (14) that contacts the oxygen-containing polycrystalline silicon film (11) on the opposite side of the substrate is covered with an insulation film (12) formed at a low temperature.

3. The semiconductor device of Claim 2 wherein the insulation film (12) formed at a low temperature is a silicon oxide film generated by a CVD method.

4. The semiconductor device of Claim 2 wherein the insulation film (12) formed at a low temperature is a silicon nitride film generated by a CVD method.

5. A manufacturing method of the semiconductor device of Claim 1 having processes of forming a field silicon oxide film (13) on the semiconductor substrate by thermal oxidation, then generating an oxygen-containing polycrystalline silicon film (11) and thermally oxidizing the surface layer of the polycrystalline silicon film.

6. The manufacturing method of a semiconductor device of Claim 5 having a process of forming an insulation film (12) at 400 °C or lower to coat it on the surface.
